# EUROPEAN PATENT APPLICATION

(11) **EP 2 819 021 A1**
(43) Date of publication of application: **31.12.2014**
(21) Application number: 12874514.8
(22) Date of filing: 16.07.2012
(51) Int. Cl.: G06F 13/00, G11C 7/24, H04L 12/02

(54) **WIRELESS COMMUNICATION TERMINAL**

(30) Priority: 16.04.2012 CN 201220158709 U
(71) Applicant: ZTE Corporation, Shenzhen, Guangdong 518057 (CN)
(72) Inventor: XIAO, Dawei, Shenzhen Guangdong 518057 (CN)
(74) Representative: Benson, Christopher
(86) International application number: PCT/CN2012/078674
(87) International publication number: WO 2013/155802

(57) **Abstract**

A wireless communication terminal, comprises: a housing and a mainboard assembly configured in said housing, and it further comprises: a USB component in which a heat source module is provided. Said USB component is configured outside the housing, and a straight plug on the USB component is connected with the heat source module, and the heat source module comprises at least a voltage conversion module; the heat source module and the mainboard assembly use an electrical connection structure. The USB component is connected to the housing. The wireless communication terminal provided in the abovementioned technical solution has a small, exquisite and beautiful structure whose surface temperature is lowered, thereby greatly improving the user experience; in addition, the structure provided in the present utility model is simple and easy to be implemented, and it does not additionally increase the cost.

## Description

### Technical Field

The present utility model relates to the field of electronics manufacturing technology, and more particularly, to a wireless communication terminal.

### Background of the Related Art

With the development of wireless communication technology, the wireless communication rate continues to increase, and the power consumption of the wireless communication terminal module also increases. According to the actual measurement, currently there is a DC to DC (DCDC) functional module on almost all wireless communication terminal module circuits, and this functional module comprises: an electrostatic protection circuit whose function is to discharge the static electricity come from the Universal serial bus (USB) interface to the card, and prevent the static electricity from breaking down the devices in the card; it further comprises: a slow start circuit whose role is to suppress the instantaneous large current on the USB interface power at the moment that it is powered on; and it comprises a DCDC conversion circuit, and the circuit comprises a DCDC chip and its peripheral circuits, and its role is to convert the 5V voltage at the USB interface to the main voltage of the circuit, for example, converting the 5V voltage to the 3.6V voltage which works as the main voltage of the circuit, or to other voltage values. However, the thermal-power consumption of the DCDC functional module can not be ignored, and currently the conversion efficiency of the DCDC chip is mostly below 90%, and if the power consumption of the wireless communication terminal module is calculated with 3.4W, a conclusion is drawn that the thermal power consumption of the DCDC functional module is 340mW, and this part of thermal power consumption can be converted into heat which leads to high surface temperature of the wireless communication terminal module, unstable performance of the wireless communication terminal module, and many other negative factors, so that the user experience becomes worse.

### Summary of the Utility Model

According to the abovementioned problem, the embodiment of the present utility model provides a wireless communication terminal, to reduce the volume of the wireless communication terminal module and the number of heat source devices within the housing of the wireless communication terminal module, thus reducing the surface temperature of the housing.

To achieve the abovementioned objective, the embodiment of the present utility model applies the following technical solution:
a wireless communication terminal, comprises a housing and a mainboard assembly configured within said housing, also comprising a universal serial bus (USB) component in which a heat source module is configured, and said USB component is configured outside said housing, a straight plug of said USB component is connected to said heat source module, and said heat source module comprises at least a voltage conversion module; said heat source module and said mainboard assembly use an electrical connection structure, and said USB component is connected to said housing.

Alternatively, said voltage conversion module comprises: a direct current to direct current (DCDC) conversion circuit, an electrostatic protection circuit and a slow start circuit, wherein, said DCDC conversion circuit, said electrostatic protection circuit and said slow start circuit are integrated on a same circuit board.

Alternatively, said heat source module further comprises: any one or any combination of a USB electrostatic protection circuit, a USB filter circuit, a power management circuit, and a baseband chip;
any one or any combination of said USB electrostatic protection circuit, said USB filter circuit, said power management circuit and said baseband chip are integrated with said voltage conversion module on said same circuit board.

Alternatively, said circuit board is a printed circuit board (PCB) or a thick film circuit board.

Alternatively, the straight plug of said USB component and said heat source module are configured to be electrically connected in the following manner:
said straight plug of said USB component is connected with said heat source module via a wire or flexible printed circuit (FPC); or
said straight plug of said USB component and said heat source module are configured on the same PCB board, and are connected via lines configured on said PCB board.

Alternatively, said heat source module and said mainboard assembly use an electrical connection structure in the following manner:
said heat source module and said mainboard assembly are connected via a wire or a flexible printed circuit (FPC).

Alternatively, said USB component and said housing are connected in the following manner:
said USB component is connected with said housing via a connecting shaft to achieve rotational folding of said USB component; or
said USB component and said housing are connected through a push-pull way.

Alternatively, said housing is provided with a groove matching with said USB component, and said groove is configured to place said USB component.

Alternatively, one end of said USB component is configured within said groove via said connecting shaft, and the other end of said USB component is rotationally folded by said connecting shaft and also placed within said groove.

Alternatively, said heat source module configured within said USB component and said mainboard assembly configured in said housing are connected via a leading wire of said USB component, and said leading wire is led from a rotational shaft of said USB component and is connected to an upper contact point of said mainboard assembly.

Alternatively, said heat source module configured within said USB component and said mainboard assembly configured within said housing are connected to a contact point of said mainboard assembly through cables.

Alternatively, said housing comprises an upper housing and a lower housing, and said upper housing and said lower housing mutually fit and form said housing.

The embodiment of the present utility model has the following advantages compared with the related art:
on the one hand, parts of heat source devices in the wireless communication terminal module are cut out separately from the mainboard assembly and moved from the housing of the wireless communication terminal module to the inside of the external USB component, reducing the number of heat source devices within the housing of the wireless communication terminal module, thereby reducing the surface temperature of said housing; secondly, parts of heat source devices individually cut out from the wireless communication terminal module form the heat source module configured outside the housing, correspondingly, the number of the heat source devices in the original mainboard assembly is reduced, so that the area of the mainboard assembly can be reduced, thereby reducing the volume of the wireless communication terminal module synchronously;
on the other hand, the wireless communication terminal provided in the embodiment of the present utility model has a small, exquisite and beautiful structure whose surface temperature is lowered, thus greatly improving the user experience;

In addition, the structure of the wireless communication terminal provided in the embodiment of the present utility model is simple, easy to be implemented, and it does not additionally increase the cost.

### Brief Description of the Drawings

FIG. 1 is a schematic diagram of the external structure in accordance with a first embodiment of the present utility model;
FIG. 2 is a schematic diagram of structural decomposition in accordance with a first embodiment of the present utility model;
FIG. 3 is a schematic diagram of the external structure in accordance with a second embodiment of the present utility model;
FIG. 4 is a schematic diagram of structural decomposition in accordance with a second embodiment of the present utility model;
FIG. 5 is a structural diagram of the USB component in accordance with the first embodiment of the present utility model;
FIG. 6 is a structural diagram of the USB component in accordance with the second embodiment of the present utility model;
FIG. 7 is a cross-sectional diagram of the USB component in accordance with the first embodiment of the present utility model;
FIG. 8 is a schematic diagram of internal wiring in accordance with the first embodiment of the present utility model;
FIG. 9 is a schematic diagram of internal wiring in accordance with the second embodiment of the utility model.

### Preferred Embodiments of the Present Utility Model

The present utility model provides a wireless communication terminal to reduce the volume of the wireless communication terminal module and to reduce the number of heat source devices within the housing of said wireless communication terminal module, thus reducing the surface temperature of said housing and improving the user experience.

Said wireless communication terminal comprises a housing and a mainboard assembly configured within said housing, further comprising a universal serial bus (USB) component in which a heat source module is configured, and said USB component is configured outside said housing, and the straight plug of said USB component is connected with said heat source module, and said heat source module comprises at least a voltage conversion module; said heat source module and said mainboard assembly use a electrical connection structure, and said USB component is connected to said housing.

Alternatively, said voltage conversion module comprises: a DC to DC (DCDC) conversion circuit, an electrostatic protection circuit and a slow start circuit, and said DCDC conversion circuit, said electrostatic protection circuit and said slow start circuit are integrated on the same circuit board.

Alternatively, said heat source module further comprises: any one or any combination of a USB electrostatic protection circuit, a USB filter circuit, a power management circuitry, and a baseband chip;
any one or any combination of said USB electrostatic protection circuit, said USB filter circuit, said power management circuit and said baseband chip is integrated with said voltage conversion module on the same circuit board.

Alternatively, said circuit board is a printed circuit board (PCB) or a thick film circuit board.

Alternatively, the straight plug of said USB component and said heat source module are configured to be electrically connected in the following manner:
the straight plug of said USB component is connected with said heat source module via a wire or flexible printed circuit (FPC); or
the straight plug of said USB component and said heat source module are configured on the same PCB board, and are connected via the lines configured on said PCB board.

Alternatively, said heat source module and said mainboard assembly use the electrical connection structure in the following manner:
said heat source module and said mainboard assembly are connected via a wire or flexible printed circuit (FPC).

Alternatively, said USB component and said housing are connected in the following manner:
said USB component and said housing are connected via a connecting shaft to achieve the rotational folding of said USB component; or
said USB component and said housing are connected in a push-pull way.

Alternatively, said housing is provided with a groove to match said USB component, and said groove is configured to place said USB component.

Alternatively, one end of said USB component is configured within said groove via said connecting shaft, and the other end of said USB component is rotationally folded by said connecting shaft and also placed within said groove.

Alternatively, said heat source module configured within said USB component and said mainboard assembly configured within said housing are connected with a leading wire of said USB component, and said leading wire is led from a rotational shaft of said USB component and is connected to an upper contact point of said mainboard assembly.

Alternatively, said heat source module configured within said USB component and said mainboard assembly configured within said housing are connected to a contact point of said mainboard assembly via cables.

Alternatively, said housing comprises an upper housing and a lower housing, and said upper housing and said lower housing mutually fit and form said housing.

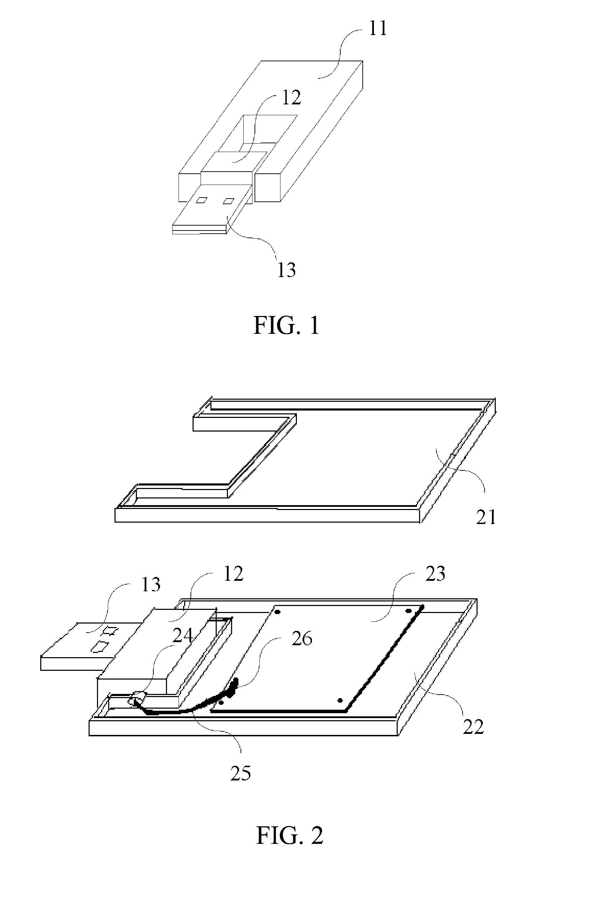

The present utility model will be further described in combination with the embodiments and the accompanying drawings:
as shown in FIG. 1, it is a schematic diagram of a structure of the first embodiment of the present utility model, comprising the housing 11 and the mainboard assembly configured within the housing 11, further comprising: the USB component 12 in which the heat source module is configured, and the straight plug 13 of the USB component 12 is connected with the heat source module; the USB component 12 is configured outside the housing 11, and the heat source module is electrically connected with the mainboard assembly, and the straight plug 13 of the USB component 12 is electrically connected with the heat source module in the following way; connected via the wire or the flexible printed circuit (FPC); or said straight plug 13 and said heat source module are configured on the same PCB and are connected via the lines on said PCB (not shown in the figure), and said USB component 12 is connected with said housing 11, and said housing is provided with a groove matching with said USB component 12 and used to place said folded USB component 12.

FIG. 2 shows a diagram of structure decomposition of the first embodiment of the present utility model, comprising the housing 11, wherein the housing is divided into the upper housing 21 and the lower housing 22, and the mainboard assembly 23 configured within the housing 11, further comprising: the USB component 12 in which the heat source module is configured, and the straight plug 13 is configured at the front end of the USB component 12, wherein said USB component 12 and said housing 11 are connected through the rotational shaft 24, further comprising the leading wire 25 of said USB component 12 to connect the heat source module with the mainboard assembly 23, and said leading wire 25 is led from the center of the rotational shaft 24 and is connected to the contact point 26 of the mainboard assembly 23.

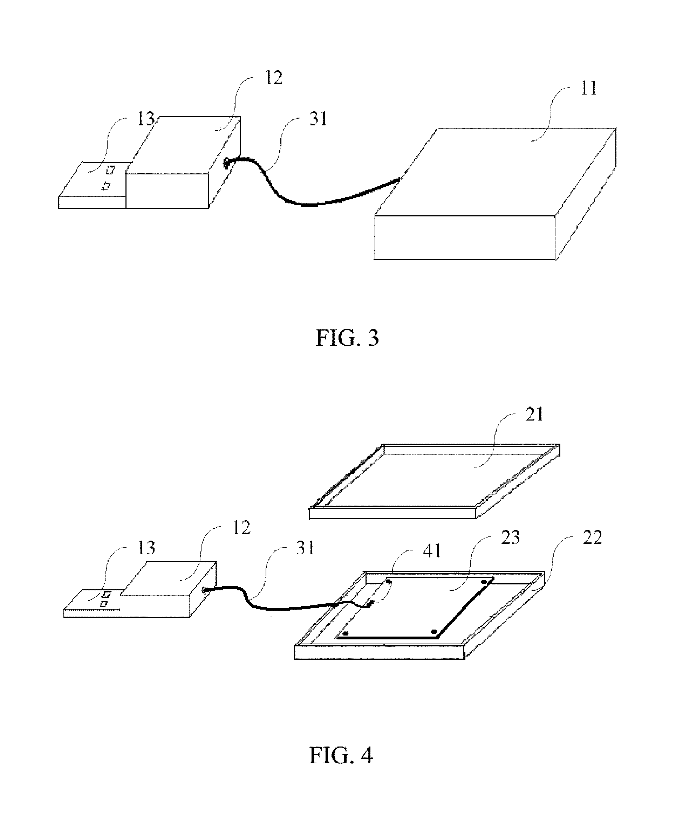

FIG. 3 shows a schematic diagram of the external structure of the second embodiment of the present utility model, and in the present embodiment, it comprises the housing 11, and the mainboard assembly configured within said housing 11, and it further comprises: the USB component 12 in which the heat source module is configured, wherein the straight plug 13 is configured at the front end of the USB component 12, and the difference is that the USB component 12 and the housing 11 are connected through the cable 31, and said cable 31 on the one hand plays the role of physically connecting the USB component 12 and the housing 11, and on the other hand it is also the electrical connection wire between the heat source module and the mainboard assembly 23.

FIG. 4 is the exploded view of FIG. 3, and it further illustrates the internal structure of the housing 11 and the wiring mode, comprising the housing 11 and the mainboard assembly provided within the housing 11, further comprising: the USB component 12 in which the heat source module is configured, and the straight plug 13 is provided at the front end of the USB component 12, wherein the housing 11 comprises the upper housing 21 and the lower housing 22, and the mainboard assembly 23 provided within the housing 11, further comprising: the USB component 12 in which the heat source module is configured, and the heat source module and the mainboard assembly 23 are connected to the contact point 41 on the mainboard assembly 23 through the signal leading wire 31. Said signal leading wire 31 can be a cable.

Although the structural diagrams of the utility model shown in FIG. 1 to FIG. 4 only show two external structure diagrams according to the embodiments of the present utility model, of course there are also other external structures, for example: the push-pull structure is used between the USB component and the housing, and when idle, the USB component can be retracted inside the housing, and when the device is in use, the USB component is pushed out, and no matter what appearance is applied, as long as the scheme is consistent with the technical solution of the embodiment of the present utility model, it should belong to the protection scope of the present utility model.

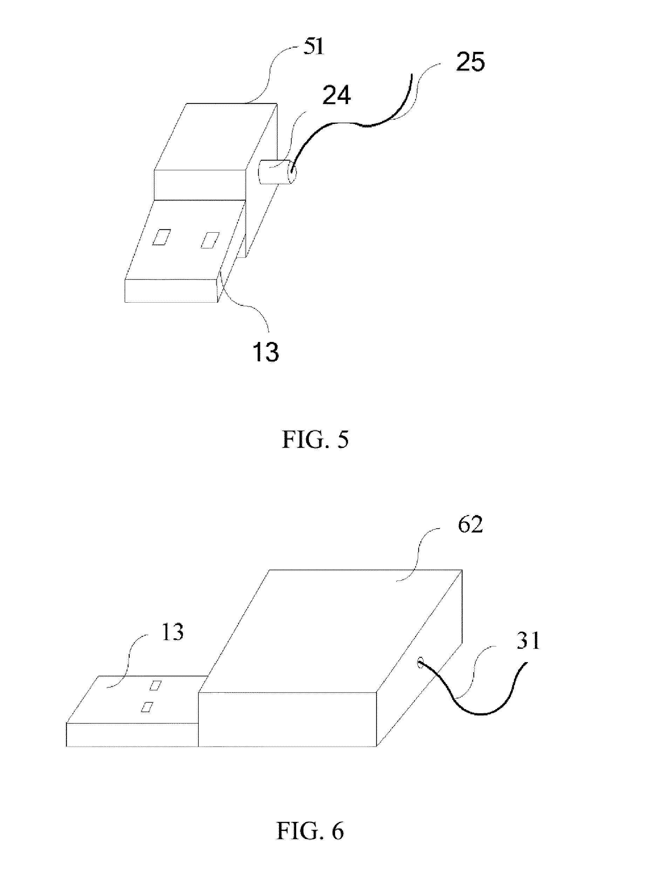

FIG. 5 is a schematic diagram of the USB component 12 in the first embodiment of the present utility model, comprising: the USB component body 51, the USB straight plug 13 provided at the front end, and said USB component body 51 is connected to the housing of the wireless communication terminal via the rotational shaft 24, and the signal leading wire 25 connecting the heat source module with the mainboard assembly within the USB component body 51 extends to the outside of the USB component body 51 through the center of the rotational shaft 24, and the leading wire 25 may be a general wire, or may also be of the flexible printed circuit (FPC) material.

Said heat source module comprises a voltage conversion module, an electrostatic protection circuit unit, a power management circuit unit and a baseband chip, and said electrostatic protection circuit unit, said power management circuit unit and said baseband chip are integrated with said voltage conversion module on the same circuit board. Wherein, said circuit board is specifically a PCB or a thick film circuit board.

FIG. 6 shows the structure of the USB component in accordance with the second embodiment of the present utility model, comprising the USB straight plug 13, the USB component body 62 and the signal leading wire 31 connecting the heat source module with the mainboard assembly within the USB component body, and the leading wire 31 extends to the outside of the USB component body and is connected with the main body in the housing, wherein the heat source module is shown in FIG. 5 and is not repeated here. The signal leading wire 31 can be a cable.

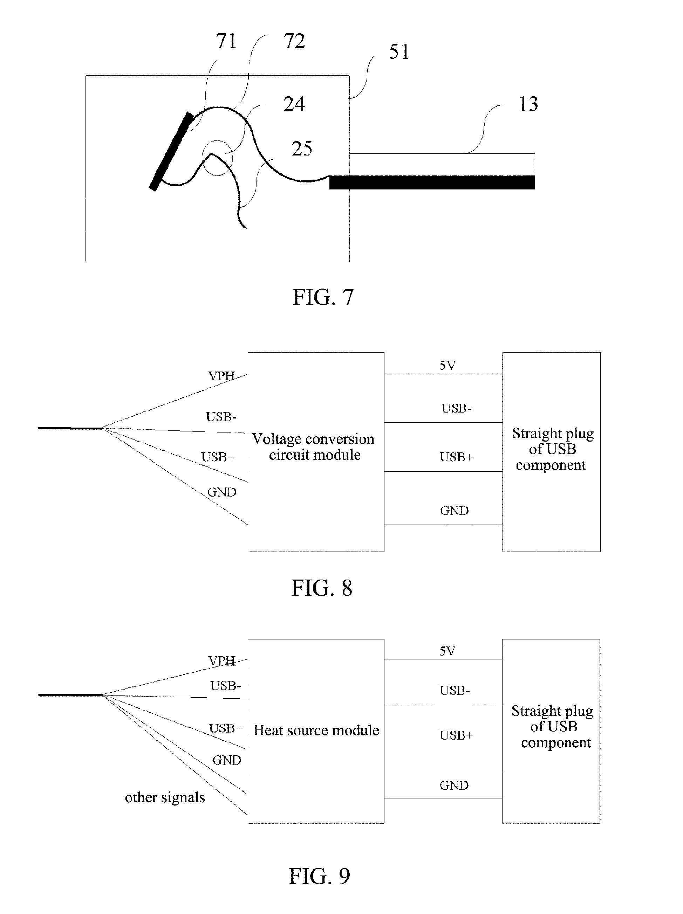

FIG. 7 is a cross-sectional view of the USB component in accordance with the first embodiment of the present utility model, and shows the mounting mode and the wire connection mode of the heat source module inside the USB component, in FIG. 7, it comprises: the USB component body 51, the USB straight plug 13, the heat source module 71 and the connecting wire 72 connecting the heat source module 71 and the USB straight plug 13, and in the present embodiment, said connecting wire 72 is specifically a wire or FPC, of course, other connection modes may be used, for example, the straight plug and the heat source module are configured on the same PCB board and are connected with lines configured on said PCB board; wherein, the USB component body 51 is connected to the housing of the wireless communication terminal via the rotational shaft 24, and the signal leading wire 25 connecting the heat source module with the mainboard assembly within the USB component body 51 extends to the outside of the USB component body 51 through the center of rotational shaft 24. Specifically, the USB component body and the housing are mechanically connected or connected with cables, and they are connected via the rotational shaft in the present embodiment, to achieve the rotational folding of said USB component.

FIG. 8 is a diagram showing the internal wiring of the USB component in accordance with the first embodiment of the present utility model, wherein the four signals 5V, USB-, USB+ and GND of the straight plug of USB component are connected to the voltage conversion circuit module in the heat source module, and the voltage conversion circuit module converts 5V to VPH, and said VPH may be 3.6V or other voltage values, and the USB- and USB+ are connected to the voltage conversion circuit module to perform electrostatic protection and filtering, and then VPH, USB-, USB+ and GND are bundled together as one leading wire extending to the outside of the USB component, and said leading wire can be the wire or flexible printed circuit (FPC).

FIG. 9 is a diagram showing the internal wiring of the USB component in accordance with the second embodiment of the present utility model, and different from the internal wiring shown in FIG. 8, besides the signals VPH, USB-, USB+ and GND, there are other signals in the leading wire of the voltage conversion circuit module. For the heat source module, besides the DCDC voltage conversion circuit module, the electrostatic protection circuit and the USB filter circuit, other circuits, such as the power management circuit and even the baseband chip and so on, can be cut from the mainboard assembly, therefore, the leading wire of the heat source module may also comprise other signal lines besides the power supply and the USB signal.

The abovementioned FIG. 8 and FIG. 9 only show two internal wiring modes of the USB component, and of course, there are other wiring modes, for example, the USB- and USB+ do not pass through the DCDC voltage conversion circuit module, but go directly across the DCDC voltage conversion circuit module and are bundled with VPH and GND as one leading wire extending to the outside of the USB component, regardless of the wiring mode, as long as the technical solution is consistent with the technical solution of the embodiment of the present utility model, it should belong to the protection scope of the present utility model.

Obviously, those skilled in the art can make various changes and modifications of the present utility model without departing from the spirit and scope of the present utility model. Thus, if the modifications and variations of the utility model belong to the scope of the claims and equivalent technologies of the present utility model, the present utility model is also intended to comprise these changes and modifications.

### Industrial Applicability

In the present utility model, on the one hand, parts of heat source devices in the wireless communication terminal module are cut out separately from the mainboard assembly and moved from the housing of the wireless communication terminal module to the inside of the external USB component, reducing the number of heat source devices within the housing of the wireless communication terminal module, thereby reducing the surface temperature of the housing; secondly, parts of heat source devices individually cut out from the wireless communication terminal module form the heat source module configured outside the housing, correspondingly, the number of the heat source devices in the original mainboard assembly is reduced, so that the area of the mainboard assembly can be reduced, thereby reducing the volume of the wireless communication terminal module synchronously; on the other hand, the wireless communication terminal provided in the embodiment of the present utility model has a small, exquisite and beautiful structure whose surface temperature is lowered, thus greatly improving the user experience; in addition, the structure of the wireless communication terminal provided in the embodiment of the present utility model is simple, easy to be implemented, and it does not additionally increase the cost. Therefore, the present utility model has a strong industrial applicability.

## Claims

1. A wireless communication terminal, comprising a housing and a mainboard assembly configured within said housing, further comprising a universal serial bus (USB) component in which a heat source module is configured, said USB component configured outside said housing, a straight plug of said USB component connected to said heat source module, and said heat source module comprising at least a voltage conversion module; said heat source module and said mainboard assembly using an electrical connection structure, and said USB component connected to said housing.

2. The wireless communication terminal of claim 1, wherein, said voltage conversion module comprises: a direct current to direct current (DCDC) conversion circuit, an electrostatic protection circuit and a slow start circuit, wherein said DCDC conversion circuit, said electrostatic protection circuit and said slow start circuit are integrated on a same circuit board.

3. The wireless communication terminal of claim 1 or 2, wherein, said heat source module further comprises: any one or any combination of a USB electrostatic protection circuit, a USB filter circuit, a power management circuit, and a baseband chip;
any one or any combination of said USB electrostatic protection circuit, said USB filter circuit, said power management circuit and said baseband chip are integrated with said voltage conversion module on the same circuit board.

4. The wireless communication terminal of claim 2 or 3, wherein, said circuit board is a printed circuit board (PCB) or a thick film circuit board.

5. The wireless communication terminal of claim 1, wherein, said straight plug of said USB component and said heat source module are configured to be electrically connected in a following manner:
said straight plug of said USB component connected with said heat source module via a wire or flexible printed circuit (FPC); or
said straight plug of said USB component and said heat source module configured on a same PCB board, and connected via wires configured on said PCB board.

6. The wireless communication terminal of claim 1, wherein, said heat source module and said mainboard assembly use an electrical connection structure in a following manner:
said heat source module and said mainboard assembly connected via a wire or a flexible printed circuit (FPC).

7. The wireless communication terminal of claim 1, wherein, said USB component and said housing are connected in a following manner:
said USB component connected with said housing via a connecting shaft to achieve rotational folding of said USB component; or
said USB component and said housing being connected through a push-pull way.

8. The wireless communication terminal of claim 7, wherein, said housing is provided with a groove matching with said USB component, and said groove is configured to place said USB component.

9. The wireless communication terminal of claim 8, wherein, one end of said USB component is configured within said groove via said connecting shaft, and the other end of said USB component is rotationally folded by said connecting shaft and also placed in said groove.

10. The wireless communication terminal of claim 1, wherein, said heat source module configured within said USB component and said mainboard assembly configured in said housing are connected via a leading wire of said USB component, and said leading wire is led from a rotational shaft of said USB component and connected to an upper contact point of said mainboard assembly.

11. The wireless communication terminal of claim 1, wherein, said heat source module configured within said USB component and said mainboard assembly configured within said housing are connected to a contact point of said mainboard assembly through cables.

12. The wireless communication terminal of claim 10 or 11, wherein, said housing comprises an upper housing and a lower housing, and said upper housing and said lower housing mutually fit and form said housing.
